# EUROPEAN PATENT SPECIFICATION

(11) **EP 4 287 278 B1**
(45) Date of publication and mention of the grant of the patent: **26.03.2025**
(21) Application number: 22176054.9
(22) Date of filing: 30.05.2022
(51) Int. Cl.: H01L 31/18, H01L 21/22, H01L 21/223, H01L 21/268, H01L 31/078, H10K 30/57

(54) **METHOD AND DEVICE FOR DOPING A MATERIAL**
VORRICHTUNG UND VERFAHREN ZUR DOTIERUNG EINES MATERIALS
PROCÉDÉ ET DISPOSITIF DE DOPAGE D'UN MATÉRIAU

(43) Date of publication of application: 06.12.2023
(73) Proprietor: Faculdade de Ciências, Universidade de Lisboa, 1749-016 Lisboa (PT)
(72) Inventor: Lobato, Killian Paolo Kiernan, 2710-734 Lourel, Sintra (PT); Gaspar, Guilherme Manuel Morais, 2040-071 Boiças, Rio Maior (PT); Serra, Filipe Carreira, 1700-017 Lisboa (PT)
(74) Representative: Weickert, Jonas

(56) References cited:
- WO-A1-2016/090179
- US-A- 5 565 377
- US-A1- 2012 329 288
- KERRIEN G ET AL: "Gas immersion laser doping (GILD) for ultra-shallow junction formation", THIN SOLID FILMS, ELSEVIER, AMSTERDAM, NL, vol. 453-454, 1 April 2004 (2004-04-01), pages 106 - 109, XP004495207, ISSN: 0040-6090, DOI: 10.1016/J.TSF.2003.11.151

## Description

The invention relates to a method and a device for producing a doped material, in particular a doped semiconductor.

Doping of materials is widely used to fabricate semiconductors with tailored electrical properties. By doping a material, impurities, also referred to as dopants, are intentionally incorporated into a material to modulate its electrical and/or optical properties. This is achieved by shifting energy bands relative to the Fermi level by doping a material, generating tailored energy band profiles along a spatial extent. Furthermore, by doping the material with different dopant types, it is possible to generate p-n-junctions inside the material, whose electrical properties are exploited in a wide range of applications such as diodes, transistors, and solar cells.

US 2012/329288 A1 discloses a system for producing a doped semiconductor. US 5 565 377 A discloses laser induced pile up of pre-existing dopants.

Dopants generally can be divided into two subgroups, p-type dopants, and n-type dopants. P-type dopants for silicon typically comprise Boron, Aluminum and/or Gallium, whereas n-type dopants for silicon typically comprise Phosphorus, Arsenic, Antimony and/or Lithium. Which dopants are suitably usable may depend on the material to be doped. For instance, n-doping of gallium arsenide may comprise substituting arsenic with tellurium or sulfur, or substituting arsenic with tin or silicon. Furthermore, p-doping of gallium arsenide may comprise substituting gallium with beryllium, zinc or chromium, or substituting arsenic with silicon, germanium or carbon.

In principle, materials can be doped during solidification, for instance during crystal growth, or by introducing dopants in the already solid material, specifically after crystallization. The subject-matter concerns a method for doping a solid material, hence methods for this are introduced in more detail. One way to produce a doped material is ion-implantation. In ion-implantation, ions of one element are accelerated to a high energy and directed to impinge on a surface of a material to be doped and by that implanted into the material. Another method is doping by diffusion, where a high concentration of a dopant is provided at a surface of the material and dopants diffuse into the material. This process is enhanced by controlling for instance the temperature of the material and/or the dopant. An additional method for doping a material is laser doping. In laser doping, a dopant is provided on the surface of the material and a laser beam is directed onto the surface such that the material partially and locally melts. Dopants move from the surface into the molten material. In the absence of the laser beam, the material rapidly solidifies and traps the dopants.

In US 2011/0185971 A1 an apparatus and a method for precisely controlling the amount of dopant, the depth of penetration of dopant and three-dimensional dopant profile is provided. This is achieved by providing a dopant on the surface of the material and incorporating the dopant into the material by applying a precisely controlled laser beam.

Many methods for controlled doping rely on vacuum processing steps, requiring time and effort. Furthermore, temperature treatments often require significant amounts of time since the material has to be heated to a target temperature and cooled down afterwards in a controlled and possibly slow manner. The fabrication of semiconductors with a controlled band structure based on doping with different dopants and controlled profiles is particularly complex.

In view of the prior art, it is an object of the present invention to achieve doping of a material in a controlled and efficient manner.

This object is achieved according to the invention by a method with the features of claim 1 and a system with the features of claim 14. Further embodiments are apparent from the dependent claims.

According to the invention, a method for producing a doped material, in particular a doped semiconductor, comprises the steps: providing a material, wherein the material comprises a surface and a first dopant in at least an area below the surface; processing the material by directing a first pulsed processing beam onto the surface of the material, wherein the processing comprises locally and temporarily melting the material such that the first dopant moves away from the surface and subsequent solidification of the previously locally molten material; providing a second dopant on the surface of the material; and incorporating the second dopant into the material by directing a second pulsed processing beam onto the surface, wherein incorporating the second dopant comprises locally and temporarily melting the material such that the second dopant moves into the material and subsequent solidification of the previously locally molten material.

Furthermore, according to the invention a system for producing a doped material, in particular a doped semiconductor, is provided, wherein the system comprises: a beam unit adapted to generate a first pulsed processing beam and a second pulsed processing beam; a processing unit adapted to receive a material comprising a surface and a first dopant in at least an area below the surface and to provide a dopant atmosphere above the surface of the material, wherein the material comprises a surface and a first dopant in at least an area below the surface; and a control unit configured to control the beam unit and the chamber such that the following steps are performed: processing the material by directing a first pulsed processing beam onto the surface of the material, wherein the processing comprises locally and temporarily melting the material such that the first dopant moves away from the surface and subsequent solidification of the previously locally molten material; providing a second dopant on the surface of the material; and incorporating the second dopant into the material by directing a second pulsed processing beam onto the surface, wherein incorporating the second dopant comprises locally and temporarily melting the material such that the second dopant moves into the material and subsequent solidification of the previously locally molten material.

In addition, the invention provides a computer program product comprising a memory and program code stored in the memory, wherein the program code is adapted to cause performance of the method for producing a doped material when the program code is executed in a processor.

The invention may also relate to program code which is adapted to cause performance of the method for producing a doped material when the program code is executed in a processor.

According to the invention, doping of a material in a controlled and efficient manner is achieved. Embodiments of the invention may be arranged to achieve precise control over a dopant concentration profile in all spatial directions. The method according to the invention may be applied on pre-processed materials, such as doped semiconductors and/or solar cells and thereby maintaining the doping profile of the pre-processed material to a desired extent. Compared to state-of-the-art methods, the invented method is fast and highly scalable to facilitate industrial applications. Another advantage of the invented method owes to the fact that doping of a material may be conducted at atmospheric pressure. Furthermore, the impingement location on the surface of the material of the pulsed processing beams may be precisely controlled such that a desired pattern may be "written" into the material. The method and device according to the invention may be arranged to dope the material with two distinct types of dopants and by that produce p-n-junctions with high control over the dopant concentration profile and hence band bending. Thereby, the concentration of both types of dopants may be accumulated to a high concentration with small spatial separation. Thus, tunnel junctions adapted to provide exceptionally low ohmic resistance may be generated by the method according to the invention. These tunnel junctions may be generated on the emitter of a pre-manufactured solar sub-cell to provide a tunnel junction for stacking another solar cell. Thereby, highly efficient tandem solar cells may be designed. Tandem solar cells comprising a tunnel junction provided by the method and/or device according to the invention may be superior to tandem solar cells comprising indium tin oxide (ITO) layers or other transparent conducting oxide (TCO) layers as a junction layer between two solar cells in terms of optical properties yielding tandem solar cells with improved efficiency.

A doped material may be any material that comprises dopants. A doped material can be provided which comprises at least one dopant, wherein the dopant concentration may be locally beneficially adjusted. A doped material could, for example, be a doped semiconductor, preferably doped silicon, GaAs, a conductive polymer or the like. The doped material may comprise any number of different dopants, wherein it comprises preferably one or two different dopants. It may be beneficial in some embodiments if different dopants are spatially separated to form different doped areas. For example, a doped material may comprise two doped areas or three doped areas, particularly with different dopants in the different areas. Dopants in each area can be arranged to define a concentration distribution of dopants along at least one axis of the material. It is understood that the properties of the doped material may be affected by the dopant concentration.

The material to be provided may comprise any material that comprises a first dopant in at least an area below the surface. The material may be defined by a regularly shaped body that comprises three orthogonal surfaces and/or extension directions with respect to a cartesian coordinate system. Two of the surfaces and/or extension directions may define the two largest faces of the body and a third surface and/or extension direction may define a thickness of the body. The provided material may comprise a thin slice of a material to be doped by the method for producing a doped material and may in particular be a silicon wafer, a solar cell and/or the like. The surface of the provided material may in particular be one of the two largest faces. The body may be a slab of material, and the surface may be a front face or a rear face of the body. In a cross-section along an axis defining the thickness of the material the area below the surface comprising the first dopant may be an approximately rectangularly shaped area extending into the material along said axis. The surface may define at least partially one side of the area or is approximately parallel to one side of the area with a distance. Said distance may not exceed the maximum penetration depth of a processing beam that is described in the following. The provided material may comprise additional dopants in other areas below the surface. For example, the material may comprise dopants in areas that are closer to the opposite face to the surface than the area comprising the first dopant. Such a material could in particular comprise a solar cell and/or form a component of a solar cell, specifically after further processing.

The above description of the shape of the material concerning regularly shaped bodies is only to be understood as an example. Doping of a material of any shape and in particular of irregular shape is within the scope of the invention. Generally, the surface is the face of the material that is processed by the processing beams and the area comprising the first dopant may be an area away from the surface inside the material. The area comprising the first dopant may be arranged to be present in an entire plane parallel to the surface. However, also multiple areas comprising the first dopant across a plane parallel to the surface are within the scope of the invention.

Providing the material may comprise pre-processing of the material. Pre-processing may be done to remove an unwanted layer on the surface, for example an oxide layer. Furthermore, pre-processing may comprise polishing and/or other methods for enhancing the surface quality. Providing the material may also comprise an additional step of doping the material to introduce the first dopant into the area below the surface. As such, the method may comprise a step of providing a material, in particular an undoped material, and a step of doping this material prior to and/or included in the above-mentioned step of providing the material. Methods for doping may be any method described later herein or any state-of-the-art method such as ion-implantation or diffusion.

The first pulsed processing beam may be arranged to melt the material locally and temporarily, wherein the material melts under the influence of the energy of a single pulse of the beam and is crystalline and/or solid in between pulses and/or without influence of the processing beam. In other words, the first pulsed processing beam may be arranged to melt the material with a single pulse in a sufficiently small region such that the molten material may solidify and/or crystalize in between single pulses of the first pulsed processing beam. The first pulsed processing beam may be any pulsed beam whose energy per pulse suffices to locally melt the material and may comprise, for example, a pulsed electron beam or a pulsed ion beam, and in a preferred embodiment of the invention a pulsed laser beam. The pulse duration of a first pulsed laser beam, in particular a pulsed laser beam, may for example be 1 fs to 100 ms, preferably be 1 ns to 1 ms and in particular be 10 ns to 100 ns. The repetition rate of pulses may for example be the reciprocal of the pulse duration and in particular be 1 kHz to 100 000 KHz. The pulse fluence, defined as the total energy per pulse per impingement area on the surface, may for example be 0.1 to 100 J/cm².

The beam unit may comprise a beam source and suitable beam guiding elements. The beam source may be a laser, an ion source and/or an electron source. Suitable guiding elements may be lenses, mirrors, diffracting elements, apertures etc. in case of a laser beam or electromagnets in case of an electron beam and/or an ion beam. In a preferred embodiment, at least one beam unit comprises a laser source. Laser sources may be of any suitable type and any wavelength. Examples of such laser sources comprise UV laser sources such as excimer laser sources (gas laser source: ArF, KrF, XeCl), e.g., with wavelengths of 193 nm, 248 nm or 308 nm, Visible light laser sources (gas laser source: Argon, HeNe), e.g., with wavelengths of 488 nm or 632.8 nm, NIR laser sources such as diode laser sources (GaAlAs) with a wavelength of 785 nm or solid state laser sources (Nd:YAG) with a wavelength of 1064 nm or IR laser sources such as solid state laser sources (Er:YAG) with a wavelength of 2.94 µm or gas laser sources (CO₂) with a wavelength of 10.6 µm.

The locally and temporarily molten material may comprise at least a part of the area that comprises the first dopant. A known physical phenomenon described in literature, for example described in Lill et al. (doi: 10.3390/ma10020189), causes the first dopants that are arranged in the molten material to move, in particular diffuse, away from the surface along the direction of the pulsed beam. The dopants may accumulate and/or pile-up towards the maximum melting depth. The maximum melting depth may be the maximum distance from the surface to the inside of the material melted during a single pulse of the first pulsed beam. The maximum melting depth can be located in the area that comprises the first dopant and/or further away from the surface in the material than the area that comprises the first dopant and may be controlled by adjusting parameters of the first pulsed processing beam such as the pulse duration, pulse energy, pulse impingement area on the surface and/or any combination thereof. At the interface between molten material and solid and/or crystalline material may be a steep temperature gradient that causes rapid solidification and/or crystallization. The molten material may solidify and/or crystallize within the same and/or a similar timescale as the first pulsed beam pulse duration upon termination of a single pulse. This rapid solidification and/or crystallization may cause embedment of the first dopant after it moved towards the maximum melting depth and thus may cause a change of the dopant concentration along the path of the first pulsed processing beam of the solid material. In particular, the dopant concentration is highest at the maximum melting depth after solidification and/or crystallization, which may also be referred to as pile-up of the first dopant. In simple words, melting the material by processing with a first pulsed processing beam at least partially comprising the area that comprises the first dopant causes the dopant to move and pile-up at the maximum melting depth. In some embodiments, the first pulsed processing beam is arranged to shape the concentration of the first dopant along the first processing beam path and thus a desired doping profile of the material comprising the first dopant can be generated. The absolute concentration of the first dopant comprised in the molten material may not change during a single pulse, but the distribution and hence local concentration of first dopant may change. Accordingly and because of the pile-up at the maximum melting depth, the area comprising the first dopant closer to the surface relative to the maximum melting depth may comprise a lower concentration of the first dopant after processing with the first processing beam than before processing with the first processing beam.

Providing the second dopant on the surface of the material may comprise any of the state-of-the-art methods for deposition of dopants on a surface. Examples of such methods non-exclusively are chemical vapor deposition, sputtering, condensation, thermal decomposition, photolytic decomposition, spin-coating, liquid immersion and gas immersion. Advantageous embodiments of the subject matter comprise methods for providing a second dopant that do not comprise the necessity of providing a vacuum. The step of providing the second dopant on the surface and/or the step of incorporating the second dopant may be vacuum-free processing steps. In some embodiments according to the invention, the second dopant may comprise for example n-type dopants such as Phosphorus, Arsenic and Antimony and/or p-type dopants such as Boron, Gallium, Indium and Aluminium and/or the like. These dopants may particularly be suitable for doping silicon. Providing the second dopant on the surface of the material may be accomplished in between single pulses of the second pulsed processing beam and thus may be arranged to provide additional second dopants before each pulse of the second pulsed processing beam. This may be advantageous if the second pulsed processing beam is repeatedly directed onto the same position on the surface of the material. That way, one can, for example, locally increase the concentration of the second dopant to match a desired absolute concentration. According to one aspect of the invention, the material comprising the second dopant may be further processed with the first pulsed processing beam according to the already described step of the method of producing a doped material to shape the doping profile of the second dopant.

The second dopant may comprise according to some aspects of the invention dopants of the same type, such as n-type dopants or p-type-dopants, be the same dopant as the first dopant and/or comprise dopants of the opposite type to the first dopant.

Processing with the second pulsed processing beam may comprise similar or the same requirements as processing with the first pulsed processing beam. The second pulsed processing beam may be arranged to melt the material locally and temporarily, wherein the material melts under the influence of the energy of a single pulse of the beam and is crystalline and/or solid in between pulses and/or without influence of the processing beam. In some embodiments, the second pulsed processing beam may be the same as the first processing beam or may comprise a beam of the same type, such as a laser beam. By adjusting parameters of the second pulsed processing beam, such as the pulse duration, pulse energy, fluence, pulse impingement area on the surface and/or any combination thereof, the maximum melting depth of the second pulsed processing beam may be arranged to fulfil an objective of processing with the second pulsed processing beam. During the timespan when the material is locally molten because of irradiation with the second pulsed processing beam, the second dopant on the surface of the material may move into the material. Upon termination of a single pulse of the second pulsed processing beam, the material may solidify and/or crystallize. This may occur analogously to the solidification and/or crystallization of the material upon termination of the first pulsed processing beam. Thus, the second dopant may be embedded into the material up to the melting depth of the second pulsed processing beam in the solid and/or crystallized processed material.

Doping the material may comprise shaping a doping profile comprising the second dopant, wherein the second dopant is the same or at least of the same type as the first dopant, such that a step profile or the like is generated. Another exemplary objective of doping the material may be to generate a doping profile comprising a first and a second dopant of a different type, e.g. one being an n-type and the other being a p-type dopant. The doping profile of each individual dopant may be shaped along the optical path of any of the pulsed processing beams. A particular objective may comprise generating junctions of p-type dopants and n-type dopants. The width of the junction may be shaped by arranging both pulsed processing beams and/or repeatedly melting the same position on the surface of the material.

According to one aspect of the invention, providing the second dopant on the surface of the material comprises providing a dopant atmosphere above the surface of the material. The dopant atmosphere may comprise a carrier gas, in particular an inert gas, such as nitrogen, argon, sulfur hexafluoride or the like. Furthermore, the dopant atmosphere may comprise the second dopant at a concentration of , for instance, 10¹⁷ cm⁻³ to 10²⁰ cm⁻³.The dopant atmosphere may be provided at atmospheric pressure. In other embodiments, the dopant atmosphere may have a pressure of at least 10 Pa or of at least 100 Pa, in other embodiments of at least 1 kPa, preferably at least 10 kPa and in particular at least 50 kPa and/or a pressure of no more than 1 MPa, preferably no more than 500 kPa and in particular no more than 200 kPa and in some embodiments no more than 100 kPa, 10 kPa or 1 kPa. In some embodiments, the pressure is between 80 kPa and 120 kPa. This is in particular advantageous as the second dopant may adsorb on the surface of the material in between each pulse of the second pulsed processing beam. Furthermore, a vacuum-free processing is possible. The steps of providing a second dopant, wherein providing the second dopant on the surface of the material comprises providing a dopant atmosphere above the surface of the material, and incorporating the second dopant may comprise a method known as Gas Immersion Laser Doping (GILD).

According to another aspect of the invention the first pulsed processing beam causes the first dopant to pile up in a pile-up area at a first distance away from the surface such that a concentration of the first dopant is highest in the pile-up area. The first pulsed processing beam may in particular be arranged to enhance the concentration of the first dopant in the pile-up area. This may be advantageous if steep changes in the doping profile comprising the first dopant are desired.

In one refinement, the second pulsed processing beam causes the second dopant to be incorporated into the material up to a second distance away from the surface. The second distance may be arranged by adjusting parameters of the second pulsed processing beam, such as the pulse duration, pulse energy, pulse impingement area on the surface and/or any combination thereof.

Furthermore, the second distance may be smaller than the first distance. Both pulsed processing beams may be attuned such that the second distance is smaller than the first distance.

According to one aspect of the invention the first dopant and the second dopant may be arranged to lead to the formation of a tunnel junction in the material. This particularly comprises attuning of both pulsed processing beams such that the second distance is smaller than the first distance, wherein the second distance is smaller by a small enough margin that a tunnel junction may be generated. Specifically, the difference between the first distance and the second distance may be smaller than 20 nm, smaller than 15 nm or even smaller than 10 nm and/or larger than 1 nm, larger than 2 nm or even larger than 7 nm.

A tunnel junction is a thin insulating layer in between two areas comprising dopants of a different type. The tunnel junction is particularly arranged to facilitate tunnelling of electrons and/or electron holes through the thin insulating layer and thus may function as an ohmic electrical contact with low resistance. This may, for example, be advantageous if the tunnel junction is integrated into a tandem solar cell. A p-n-junction of opposite direction to the direction of the preferred electron flow may arise if two single solar cells are stacked. This p-n-junction would constitute a high ohmic resistance and thus would decrease the efficiency of the tandem solar cell. A high dopant concentration in this p-n junction may reduce the depletion region of the junction. The relation between the dopant concentration and depletion region is such that the higher the dopant concentration, the smaller the depletion region. Thus, at certain dopant concentrations a tunnel junction may be formed that facilitates charge carrier tunnelling and reduces the ohmic resistance of the p-n-junction. For the formation of tunnel junctions, it may be advantageous to arrange the dopant concentrations in such a way that high concentrations of both dopants are formed, whereby the dopant concentration profiles define a local maximum with surrounding steeply decreasing concentration. In addition, it may be advantageous if the two local dopant concentration maxima are arranged so that they are in close proximity to each other. For example, they may be 100 nm, preferably 50 nm, in particular 10 nm apart.

In one embodiment the first pulsed processing beam and/or the second pulsed processing beam may be moved between different processing locations on the surface. This may be advantageous to generate varying doping profiles across the surface. It is understood that the doping profile is defined along an axis arranged to intersect the surface. Preferably, the said axis is orthogonal to the surface. It may also be advantageous to move the first pulsed processing beam and/or the second pulsed processing beam to process to iteratively process at least parts of the material and/or process different locations independently, in particular repeatedly. Furthermore, one may adjust parameters of at least one of the pulsed processing beams for processing the material at distinct locations across the surface. According to this embodiment, the first pulsed processing beam and/or the second pulsed processing beam may be rastered across the surface of the material to write doping patterns. Generally speaking, the first pulsed processing beam and/or the second pulsed processing beam can be movable in a two-dimensional plane, in particular in a plane defined by the surface.

In one refinement of the invention, the first pulsed processing beam may be applied several times onto a first location on the surface and/or the second pulsed processing beam may be applied several times onto a second location on the surface. The first and the second location may be the same position in some aspects of the invention. By applying a processing beam several times onto the same location on the surface one may advantageously adjust doping profiles along the path of the respective processing beam. In particular, one may adjust parameters of any of the first and/or second processing beam in between single pulses directed onto the same location on the surface to beneficially adjust the doping profile. Furthermore, one may further increase the concentration of a dopant in a pile-up area and in particular increase the maximum concentration, wherein the steepness of the concentration profile may be increased towards the maximum concentration.

According to some aspects of the invention, the first dopant may be different from the second dopant. The first and the second dopant may be a dopant of the same type, e.g. n-type and/or p-type.

Furthermore, one of the first dopant and the second dopant is an n-dopant and the other of the first dopant and the second dopant is a p-dopant, or wherein both the first dopant and the second dopant are n-dopants or wherein both the first dopant and the second dopant are p-dopants. Generally, the invention allows doping a material with any dopant, independently from the type of the dopant.

In some embodiments, the first pulsed processing beam and/or the second pulsed processing beam may be a pulsed laser beam. This may be beneficial as it avoids the necessity of providing specific ambient conditions such as a vacuum, an inert gas and/or the like.

The first pulsed processing beam may comprise an IR laser beam and/or the second pulsed processing beam may comprise a UV laser beam. Generally, processing beams comprising any pulsed laser beams and/or any combination thereof are within the scope of the invention. Different cases of applications may require different combinations of pulsed laser beams. In particular, the combination of the first pulsed processing beam comprising an IR beam and/or the second pulsed processing beam comprising a UV laser beam may be advantageous. Other examples for pulsed processing beam combinations may comprise IR and/or a visible laser beam, a visible and/or an IR laser beam.

However, in particular embodiments, wherein the first and the second pulsed processing beam are generated using the same beam source may be advantageous. It may then suffice to use a single beam source, in particular a near-IR laser beam source. In some cases, the first and the second pulsed processing beam may comprise the same laser beam. Using a single beam source can reduce the complexity of the processing equipment. The beam source may be adjusted differently to generate the first and the second pulsed processing beams. In other embodiments, two separate beam sources may be used which generate first and second pulsed processing beams, respectively, of the same wavelength.

According to some aspects of the invention, a temperature of the material may be adjusted to a predetermined temperature value and/or temperature profile. It may be advantageous to locally adjust the temperature of the material when processing the material with any pulsed processing beam. The temperature of the material may affect the achieved and/or achievable doping profile. The temperature of the material may be adjusted to a preferred temperature at any step of the invented method. The temperature profile may be preferably attuned with the parameters of the pulsed processing beams and may vary or may be different at different locations on the surface.

The temperature may range from 243 K to 1683 K and may be ramped up and/or down within at least parts of this range by up to 1000 K/s. In other embodiments, smaller ramps may be used, for instance ramps of 500 K/s, 200 K/s or 100 K/s. A temperature controller may be provided to adjust the temperature and/or temperature ramps. The temperature controller may be configured to control the temperature and/or the temperature ramps locally. The temperature controller may work in an open-loop or closed-loop configuration. The temperature controller may comprise at least one temperature sensor, in particular in case it is working in closed-loop configuration. Also in scope of the invention is a model-based temperature control that may be adapted to heat the material to predefined temperature values according to pre-set temperature profiles.

It is understood that the subject matter of the invention is not limited to the embodiment described above.

### Brief description of the drawings

Preferred embodiments of the invention are explained in greater detail below with reference to the appended schematic drawings, which show the following:
- Fig. 1: a system for producing a doped material;
- Fig. 2: the system for producing a doped material in a different processing state;
- Fig. 3: a schematic flowchart of a method for producing a doped material;
- Fig. 4: a schematic cross-sectional view of a material during application of a first pulsed processing beam;
- Fig. 5: a schematic cross-sectional view of the material after application of the first pulsed processing beam;
- Fig. 6: a schematic cross-sectional view of the material during application of a second pulsed processing beam;
- Fig. 7: a schematic cross-sectional view of the material after application of the second pulsed processing beam;
- Fig. 8: schematic band diagrams of the material after different processing steps;
- Fig. 9: a schematic band diagram of an example for a solar cell device fabricated using the method for producing a doped material;
- Fig. 10: schematic dopant concentration profiles for different parameters of the first pulsed processing beam;
- Fig. 11: schematic concentration profiles of a first dopant and a second dopant;
- Fig. 12: schematic dopant concentration profiles and resulting band structures for an exemplary material;
- Fig. 13: schematic dopant concentration profiles and resulting band structures for a further exemplary material;
- Fig. 14: schematic dopant concentration profiles and resulting band structures for a further exemplary material;
- Fig. 15: schematic dopant concentration profiles and resulting band structures for a further exemplary material;
- Fig. 16: schematic dopant concentration profiles and resulting band structures for a further exemplary material;
- Fig. 17: schematic dopant concentration profiles and resulting band structures for a further exemplary material;
- Fig. 18: schematic dopant concentration profiles and resulting band structures for a further exemplary material;
- Fig. 19: schematic dopant concentration profiles and resulting band structures for a further exemplary material; and
- Fig. 20: schematic dopant concentration profiles and resulting band structures for a further exemplary material.

### Detailed description

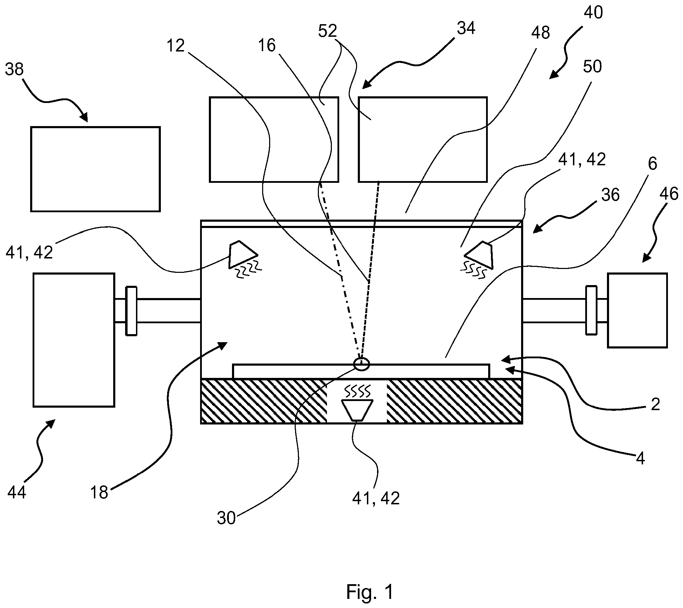

In the following, an exemplary system and method for producing a doped material are discussed in detail. Furthermore, multiple aspects of the invention are described by showing exemplary doping procedures. The procedures may be implemented in different embodiments of the invention. Likewise, some or all of the procedures may be implemented in a single embodiment of the invention, and they may be applied alternatively or in addition to one another. For example, to tailor three-dimensional electrical properties of the material, one may locally apply different procedures on a single material. Below, one preferred embodiment is described in more detail, which is a procedure for producing a tunnel junction. The invention offers high flexibility and precision in controlling doping profiles comprising two different dopant types and high locally high concentrations of these. In order to illustrate how the method comprising the different exemplary doping procedures may be applied in detail, first one exemplary embodiment of the system according to the invention is discussed. It is understood that the system may comprise multiple embodiments according to the invention, some of which are briefly mentioned in the description of figure 1 without being depicted.

Fig. 1 shows a schematic overview of one embodiment of a system 40 for producing a doped material 2, in particular a doped semiconductor, in particular using a method described below. In this embodiment, the material 4 is processed by directing pulsed laser beams 12, 16 onto the surface 6 of the material 4.

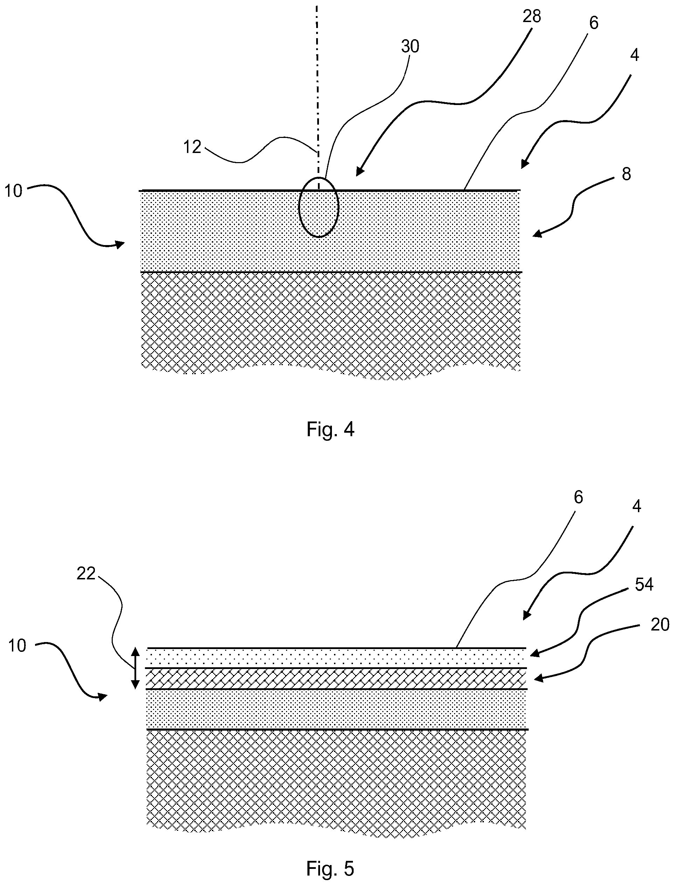

The material 4 in this particular embodiment is shown in Fig. 4 in greater detail, where a cross-section of the material 4 is depicted. The cross-section cuts the material 4 such that the pulsed laser beams 12, 16 are in parallel to the cross-section. Hence, the pulsed laser beams 12, 16 impinge on the surface 6 at a processing location 28 and are adapted to melt the material 4 along their path in proximity of the beams 12, 16. The material 4 is a silicon wafer comprising a first dopant 8 in an area 10, highlighted with a dotted pattern, below the surface 6, wherein the surface 6 defines one side of the area 10. The first dopant 8 is approximately evenly distributed in terms of concentration across the entire area 10, which is, however, not a necessity for the method according to the invention. The material 4 is arranged in a processing unit 36 that comprises a chamber 50 and a transparent window 48. The chamber 50 may be flooded with gas by means of the gas supply unit 44 to provide a dopant atmosphere 18 comprising a second dopant 14 and evacuated by means of the vacuum unit 46.

This embodiment is specifically adapted to apply Gas Immersion Laser Doping (GILD) to incorporate the second dopant 14 into the material. Alternatively or additionally, the chamber 50 may have the same ambient conditions as the space the system 40 is arranged in. Also in the scope of the invention is an embodiment of the system 40, even though not depicted, that does not comprise a chamber. A dopant may still be provided in such embodiments by locally increasing the dopant concentration around the material 4. This may be particularly useful in a continuous fabrication method.

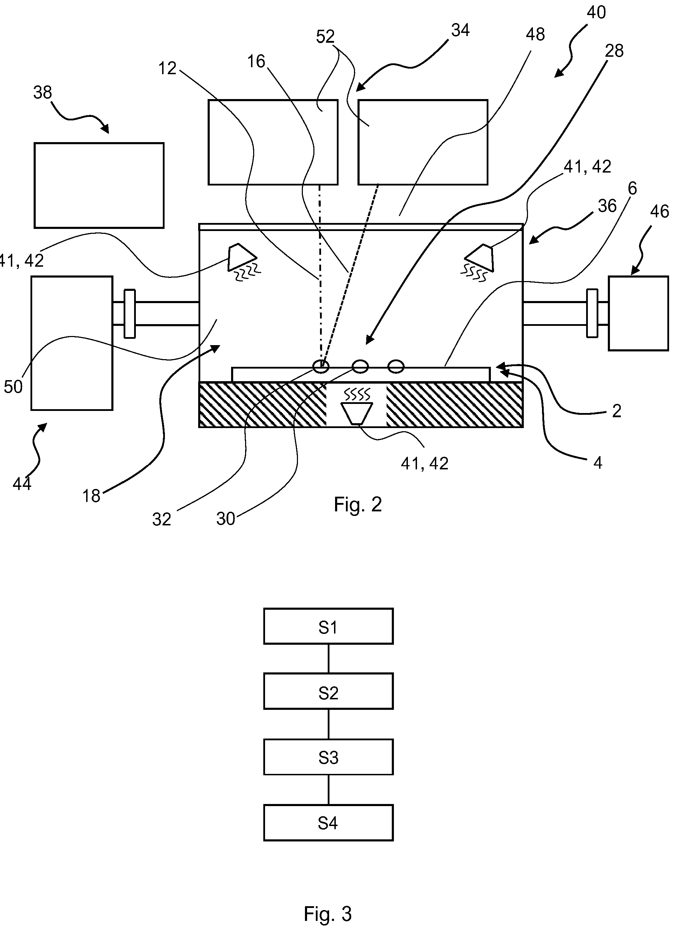

A control unit 38 is arranged to attune the processing unit 36, gas supply unit 44 and vacuum unit 46 to provide a dopant atmosphere 18 comprising the second dopant 14 around the material 4. By the control unit 38 furthermore a beam unit 34 may be controlled. The beam unit 34 in this embodiment comprises two pulsed laser beam sources 52 each of which adapted to generate a pulsed laser beam 12, 16. The directions of the pulsed laser beams 12, 16 as depicted in Fig. 1 and 2 explicitly serve illustrative purposes. It is within the scope of the invention to adapt the laser beam sources 52 such that the pulsed laser beams 12, 16 coincide and/or are oriented orthogonally to the surface 6. In this particular embodiment, the laser beam sources 52 comprise an Near-IR laser beam source (solid state laser, Nd:YAG, neodymium-doped yttrium aluminum garnet, 1064 nm wavelength) to provide the first pulsed processing beam 12 and a further Near-IR laser beam source (solid state laser, Nd:YAG, neodymium-doped yttrium aluminum garnet, 1064 nm wavelength) to provide the second pulsed processing beam 16. The first and second pulsed processing beams 12, 16 may in some cases both be generated by the same beam source.

In other embodiment, different beam sources may be used. In principle, possible beam source comprise UV excimer laser (gas source, noble gas halide, ArF, KrF, XeCl, with wavelengths of 193 nm, 248 nm, 308 nm, respectively), visible light lasers (Argon or HeNe gas source lasers with wavelenghts of 488 nm and 632.8 nm, respectively), near-IR leaser (GaAlAs (diode) laser with 785 nm wavelength or Nd:YAG, solid state, neodymium-doped yttrium aluminum garnet laser with 1064 nm wavelength) or IR lasers (Er:YAG solid state, erbium-doped yttrium aluminium garnet laser with 2.94 µm wavelength or CO₂ gas source laser with 10.6 µm wavelength). These may be combined as is suitable for the material to be processed.

In some aspects of the invention, only one pulsed processing beam 12, 16 is provided and in such cases, the first and second pulsed processing beam 12, 16 are from the same source. In other words, a single beam source may be used for generating both pulsed processing beams 12, 16. The control unit 38 is adapted to control parameters of the pulsed processing beams 12, 16 such as the pulse duration, pulse energy, pulse impingement area on the surface 6 and/or any combination thereof.

The pulsed laser beams 12, 16 may be repeatedly directed onto the same location 30 on the surface 6. The pulsed laser beams 12, 16 may enter the chamber 50 through the transparent window 48.

An optional heating device 41 is provided within the processing unit 36, which may comprise one or more heating elements 42. The heating device 41 and/or the heating elements 42 are adapted to heat the material 4 at least locally. At least one heating element 42 may be adapted to heat the material at different locations such that controlled temperature profiles across the material may be provided. In the present embodiment, heating elements 42 are arranged above and below the material 4. The heating device 41 may be connected to the control unit 38, which may implement a temperature controller, or to a separate temperature controller. The temperature controller in the shown embodiment is configured to adjust a temperature and/or temperature profile of the material 4 to a predetermined temperature and/or temperature profile. Specifically, the material 4 may be heated to a temperature closer to the melting point, such that a smaller amount of energy is necessary to be input by the pulsed processing beams 12, 16 for locally melting the material 4. Further advantages of heating the material are that temperature gradients induced by the absorption of the beam are reduced. Reducing the temperature gradients ensures that the whole material is processed under the same conditions as the beam rasters the surface 6. Controlling the temperature of the material 4 particularly allows controlling how the incident pulsed processing beam 12, 16 is absorbed. For laser radiation, absorption increases with semiconductor temperature.

As shown in Fig. 2 the pulsed processing beams 12, 16 are arrangeable such that they may be directed to any processing location 28. In Fig. 2, they are directed onto a second location 32. In particular, the pulsed laser beams 12, 16 may be rastered across the entire surface 6 of the material 4. Alternatively or additionally, they may be directed on to the same processing location 28, for example first location 30 or second location 32, repeatedly. Generally, the pulsed laser beams 12, 16 may at any time be directed onto any location across the surface 6 of the material 4 during processing of the material 4.

In the following, the method for producing a doped material is discussed in greater detail with reference to multiple aspects of the invention. In the course of the discussion, it is referred to the general schematic overview of the method comprising the steps S1 to S4 as depicted in Fig. 3.

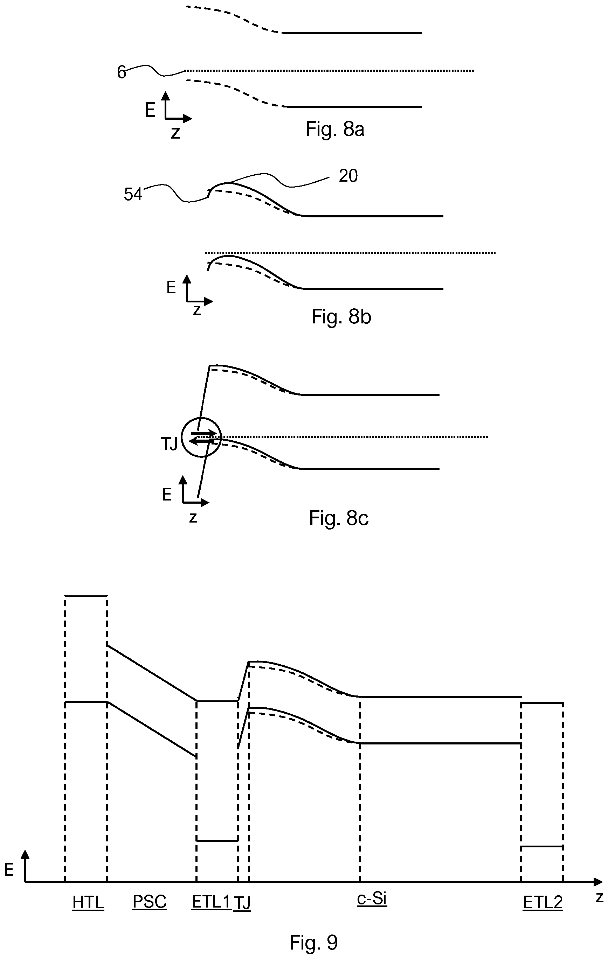

In the shown case, the method is a method for producing a doped material 2 comprising a tunnel junction. A step-by-step procedure for producing a doped material 2 comprising a tunnel junction according to one aspect of the invention is shown in Figs. 4-7 and a corresponding band diagram of the doped material 2 is shown in Fig. 8. As shown in Fig. 4, a material 4 is provided (S1, Fig. 3). According to this example, the first dopant 8 is a p-type dopant. The material 4 may comprise further dopants and/or functional layers of other materials further away from the surface 6 which are not depicted. Below the area 10 comprising the first dopant 8 may be any concentration of any dopant in this particular embodiment. The material 4 is provided such that it is ready for being processed by the first pulsed processing beam 12 (S2, Fig. 3).

In Fig. 5, the material 4 is shown after being processed by the first pulsed laser beam (S2, Fig. 3). The processing with the first pulsed laser beam is done according to the technique described in Lill et at. (doi: 10.3390/ma10020189). The material 4 may be homogeneously processed across the entire shown surface 6 by the first pulsed laser beam 12. Processing with the first pulsed laser beam 12 according to S2 caused a pile-up of the first dopant 8 in a pile-up area 20 at a first distance 22 to the surface 6. Hence, the concentration of the first dopant 8 is highest in the pile-up area 20. Since the total dopant concentration of the first dopant 8 across the entire area 10 does not change during processing with the first pulsed laser beam 12, a depleted area 54 arises comprising a lower dopant concentration than before processing with the first pulsed laser beam 12. In other words, the first dopant 8 moved towards the maximum melting depth of the first pulsed laser beam 12 to accumulate and/or pile-up around said maximum melting depth. The first distance 22 to the surface 6 may be understood as the distance from the surface 6 to the maximum dopant concentration.

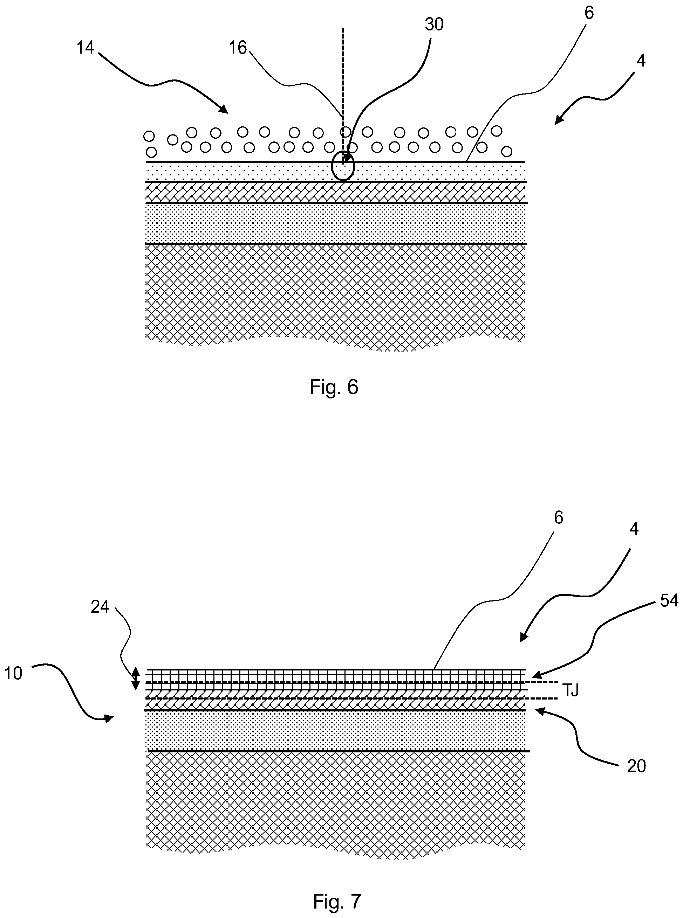

In a next step (S3, Fig. 3), the second dopant 14 is provided on the surface 6 of the material 4. In the exemplary embodiment of the invention depicted in Figs. 1 and 2, the second dopant 14 is provided by providing a dopant atmosphere 18 comprising the second dopant 14. Exemplarily, the second dopant 14 is an n-type dopant. This may be done in a controlled manner by the control unit 38 such that the concentration of the second dopant 14 on and/or above the surface 6 may precisely be adjusted. Specifically, the atmosphere of the second dopant 14 is provided by controlling the gas supply unit 44 and the vacuum unit 46, for instance by setting a persistent gas flow and/or by introducing the second dopant 14 at a target pressure and/or concentration in the chamber 50 by controlled operation of the gas supply unit 44 and/or the vacuum unit 46 and subsequent closing-off of the chamber and/or temporary deactivation of the gas supply unit 44 and/or the vacuum unit 46. The result of providing the second dopant 14 above and/or on the surface 6 is shown in Fig. 6.

The second pulsed processing beam 16 is applied to the material 4, thus incorporating the second dopant 14 into the material 4. The second pulsed processing beam 16 locally melts the material 4 and the second dopant 14 moves into the material.

Fig. 7 shows the result of incorporating the second dopant 14 into the material 4. The second dopant 14 on the surface 6 of the material was incorporated into the material 4 by directing the second pulsed laser beam 16 onto the surface 6 of the material 4 (S4, Fig. 3).

By processing the material 4 with the second pulsed processing beam 16, the material 4 locally and temporarily melts such that the second dopant 14 moves into the molten material up to second distance 24 defined by a melting depth of the second pulsed laser beam 16. The second distance 24 hence may be adapted by controlling parameters of the second pulsed laser beam 16 and preferably, according to this exemplary embodiment, be adapted to be smaller than the first distance 22 (see Fig. 5). After termination of a single pulse of the second pulsed laser beam 16 the molten silicon rapidly crystallizes and traps the second dopant 14 in the formerly depleted area 54 such that the second dopant is embedded in the crystal structure. The depleted area 54 comprises the second dopant after processing according to S4 of the invention. This area is hence depleted from the first dopant 8 but now comprises the second dopant 12.

By choosing a sufficiently small differential distance, a tunnel junction (TJ) may form between the pile-up area 20 comprising highly concentrated p-type dopants and the formerly depleted area 54 enriched with the n-type dopant (second dopant 14). The second distance 24 in this particular example was chosen to be 20 nm smaller than the first distance 22, i.e., the differential distance is 20 nm in the present example. The differential distance preferably is in the range between 1 nm and 100 nm. Furthermore, the first distance 22 exemplarily is 350 nm and the second distance 24 exemplarily is 330 nm.

The combination of S3 and S4, namely providing the second dopant 14 on the surface 6 of the material 4 and directing the second pulsed laser beam 16 onto the surface 6 of the material 4 to incorporate the second dopant 14 into the material may be a variant of Gas Immersion Laser Doping (GILD) in this particular embodiment. Detailed descriptions of GILD may be found in scientific literature, for example in Carey and Sigmon (doi: 10.1063/1.118409), Kerrien et al. (doi: 10.1016/j.tsf.2003.11.151) and Cammilleri et al. (doi: 10.1016/j.tsf.2008.08.073). Reference is made to the specifics of the GILD process described therein.

Fig. 8 shows band diagrams of the material 4 in different steps of the method. Fig. 8a shows a band diagram in the situation illustrated in Fig. 4. Fig. 8b shows a band diagram in the situation illustrated in Fig. 5. Fig. 8c shows a band diagram in the situation illustrated in Fig. 7. The diagrams show a spatial dimension z of the material 4 on the abscissa and energy E on the ordinate, wherein the starting point of the diagrams on the spatial axis are at least close to the surface 6 of the material 4.

In Fig. 8a, there is a band bending owing to the first dopant 8 in the area 10 below the surface 6.

By processing with the first pulsed laser beam 12 and thereby changing the concentration profile of the first dopant 8, the bands are locally lifted to form local maxima, whereby the bands are lowered below the initial band to the left of the maxima. This band structure shown in Fig. 8b corresponds to the pile-up area 20 and depleted area 54 as shown in Fig. 5.

The band structure of the doped material 2 comprising the tunnel junction (TJ) is shown in Fig. 8c. By incorporating the second dopant 14 into the material up to a second distance 24 smaller than the first distance 22, for example 10 nm or 20 nm smaller, a steep change of the bands is arranged inside the material. With short distance, for example 10 nm or 20 nm, to the local maximum of the bands a local minimum of the bands is arranged. By that, a tunnel junction is formed between the oppositely doped areas 20, 54 providing a low ohmic resistance arranged, for instance, in a tandem solar cell.

A doped material 2 as provided by the method and/or system 40 may be arranged in conjunction with other semiconductor materials and/or incorporated in any device in which it is suitably usable.

As one example for incorporating a tunnel junction fabricated as described above in a semiconductor device, Fig. 9 shows a band diagram of a perovskite (PSC) silicon (Si) tandem solar cell. Specifically, a monolithically integrated PSC/Si solar cell can be fabricated. The silicon may be crystalline silicon (c-Si). The perovskite may in particular be an organic-inorganic perovskite, such as a lead or tin halide-based material, or an inorganic perovskite, such as CsPb halide perovskites. As exemplarily shown in Fig. 9, such a device may comprise a hole transporting layer HTL, a PSC layer, a first electron transporting layer ETL1, a p-n c-Si solar cell with a tunnel junction fabricated as discussed above and a second electron transporting layer ETL2.

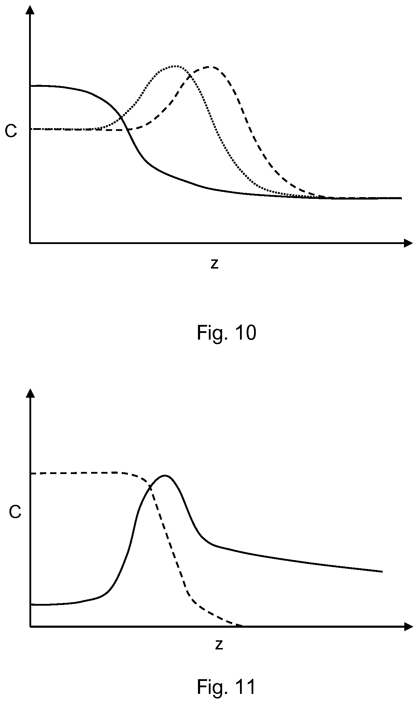

Fig. 10 illustrates concentration profiles of the first dopant 8 in the material 4 below the surface 6. Where reference is made to concentration profiles herein, it is to be understood that this may relate to a number per volume. The abscissa indicates a spatial coordinate z, in particular a distance from the surface 6, specifically parallel to a normal direction of the surface 6. The ordinate indicates a concentration C of first dopant 8. The solid line illustrates the first dopant 8 concentration as provided before processing with the first pulsed processing beam 12. By controlling parameters of the first pulsed processing beam 12 and/or numbers of times of its application, the first distance 22 (see Fig. 5) can be adjusted such that the first dopant 8 piles-up at different first distances. For instance, the dotted line illustrated a concentration profile after a single shot on a given first location 30. If the first pulsed processing beam 12 is applied to the same first location 30 repeatedly, the first dopant 8 is allowed to move deeper into the material 4, leading to the concentration profile indicated by the dashed line.

This may be done at different first locations 30, for instance by rastering or otherwise moving the first pulsed processing beam 12 across the surface 6, e. g. in an x-y plane. At each first location 30, the first pulsed processing beam 12 may be applied at least once, specifically once or twice or several times, for instance to control the first depth. Using this approach, it is possible to control the concentration profile of the first dopant 8 in said x-y plane, or put otherwise, across the surface 6 of the material. The same material 4 can thus be provided with different doping profiles at different locations.

Likewise, the concentration profile of the second dopant 14 can be adjusted by adjusting parameters of the second pulsed processing beam 16. The second pulsed processing beam 16 can be applied at a second location 32. This can be done once or several times, such that the second dopant 14 can be allowed to move to a desired depth into the material 4. The mechanism is similar or identical to the mechanism described above for the first dopant 8.

The second pulsed processing beam 16 can be focused at different second locations 32, for instance by rastering or otherwise moving the second pulsed processing beam 16 across the surface 6, e. g. in an x-y plane. At each first location 30, the first pulsed processing beam 12 may be applied at least once, specifically once or twice or several times, for instance to control the first depth. Using this approach, it is possible to control the concentration profile of the first dopant 8 in said x-y plane, or put otherwise, across the surface 6 of the material. The same material 4 can thus be provided with different doping profiles at different locations.

Fig. 11 illustrates concentration profiles of the first dopant 8 and the second dopant 14. The abscissa indicates a spatial coordinate z, in particular a distance from the surface 6, specifically parallel to a normal direction of the surface 6. The ordinate indicates a concentration C of the first dopant 8 and the second dopant 12. The absolute values are not necessarily drawn to scale. The concentration profile of the first dopant 8 is shown as solid line, the concentration profile of the second dopant 12 is shown as dashed line. The concentration profiles indicate pile-up of the first dopant at a first distance or melt depth below the surface 6 and a uniform concentration profile of the second dopant up to a second distance or melt depth away from the surface 6. Furthermore, as can be seen in Fig. 11, there is a depth difference such that concentration maxima of the first dopant 8 and the second dopant 12 do not coincide but are spaced apart. In the present case, this spacing is in the order of 10 nm or 20 nm, such that a tunnel junction is formed, as described above.

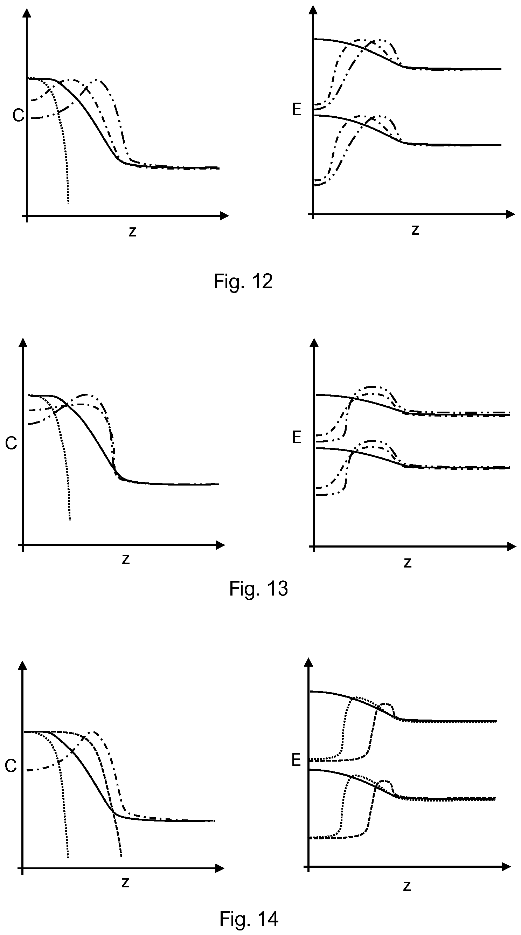

It is clear from the above description that other concentration profiles and hence other band structures can be fabricated using the method and system disclosed herein. Examples for band structures are shown in Figs. 12 to 20. In each case, two schematic diagrams are shown. On the left-hand side of each figure, a diagram is shown illustrating concentration profiles. In these diagrams, the abscissa indicates a spatial coordinate z, in particular a distance from the surface, specifically parallel to a normal direction of the surface, and the ordinate indicates a concentration C of the respective dopants. On the right-hand side of each diagram, resulting band structures are shown. These diagrams show a spatial dimension z of the material on the abscissa and energy E on the ordinate, wherein the starting point of the diagrams on the spatial axis are at least close to the surface of the material.

Fig. 12 illustrates the method starting with a p++ emitter. The initial concentration profile and the initial band structure are indicated by solid lines in the left-hand side and right-hand side diagrams, respectively. In this example, the first dopant is a p-type dopant, and the second dopant is an n-type dopant. By application of the first pulsed processing beam, dopant is moved deeper into the material. The depth and the resulting pile-up can be controlled by controlling the processing parameters. In the left-hand side diagram, the resulting concentration profiles of the first dopant for two different treatments with the first pulsed processing beam are shown as dash-dotted line and as dash-dot-dotted line, respectively. The first pulsed processing beam is applied and adjusted such that the maximum depth at which the pile-up occurs is changed. In both cases, second dopant is incorporated into the material using the second pulsed processing beam as described above, resulting in a concentration profile of second dopant as indicated by the dotted line. The two different overall resulting concentration profiles, which differ by the concentration profiles of the first dopant, lead to two different band structures, indicated by the dash-dotted line and the dash-dot-dotted line in the right-hand side diagram.

Fig. 13 illustrates the method starting with a p++ emitter. The initial concentration profile and the initial band structure are indicated by solid lines in the left-hand side and right-hand side diagrams, respectively. In this example, the first dopant is a p-type dopant, and the second dopant is an n-type dopant. By application of the first pulsed processing beam, dopant is moved deeper into the material. The depth and the resulting pile-up can be controlled by controlling the processing parameters. In the left-hand side diagram, the resulting concentration profiles of the first dopant for two different treatments with the first pulsed processing beam are shown as dash-dotted line and as dash-dot-dotted line, respectively. The first pulsed processing beam is applied and adjusted such that the maximum depth at which the pile-up occurs is the same for both cases, but the pile-up effect is stronger, i.e., the first dopant is more concentrated at a certain depth in case of the dash-dot-dotted line. In both cases, second dopant is incorporated into the material using the second pulsed processing beam as described above, resulting in a concentration profile of second dopant as indicated by the dotted line. The two different overall resulting concentration profiles, which differ by the concentration profiles of the first dopant, lead to two different band structures, indicated by the dash-dotted line and the dash-dot-dotted line in the right-hand side diagram.

Fig. 14 illustrates the method starting with a p++ emitter. The initial concentration profile and the initial band structure are indicated by solid lines in the left-hand side and right-hand side diagrams, respectively. In this example, the first dopant is a p-type dopant, and the second dopant is an n-type dopant. By application of the first pulsed processing beam, dopant is moved deeper into the material. The depth and the resulting pile-up can be controlled by controlling the processing parameters. In the left-hand side diagram, the resulting concentration profile of the first dopant for one exemplary treatment is shown as dash-dotted line. Second dopant is incorporated into the material using the second pulsed processing beam as described above. This can be done using different processing parameters, resulting in different concentration profiles of the second doping, as exemplarily shown in the left-hand side figure as dotted line and dashed line, respectively. The two different overall resulting concentration profiles, which differ by the concentration profiles of the second dopant, lead to two different band structures, indicated by the dotted line and the dashed line in the right-hand side diagram.

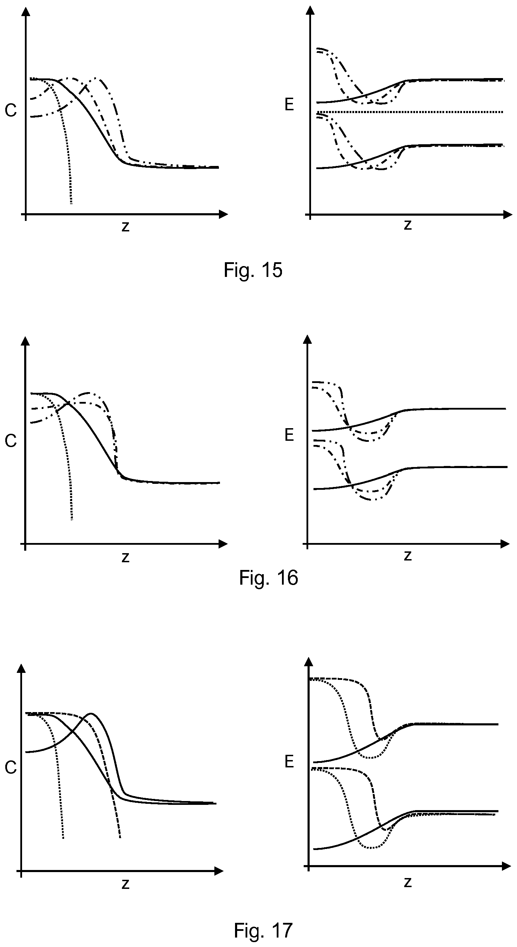

Fig. 15 illustrates the method starting with an n++ emitter. The initial concentration profile and the initial band structure are indicated by solid lines in the left-hand side and right-hand side diagrams, respectively. In this example, the first dopant is an n-type dopant, and the second dopant is a p-type dopant. By application of the first pulsed processing beam, dopant is moved deeper into the material. The depth and the resulting pile-up can be controlled by controlling the processing parameters. In the left-hand side diagram, the resulting concentration profiles of the first dopant for two different treatments with the first pulsed processing beam are shown as dash-dotted line and as dash-dot-dotted line, respectively. The first pulsed processing beam is applied and adjusted such that the maximum depth at which the pile-up occurs is changed. In both cases, second dopant is incorporated into the material using the second pulsed processing beam as described above, resulting in a concentration profile of second dopant as indicated by the dotted line. The two different overall resulting concentration profiles, which differ by the concentration profiles of the first dopant, lead to two different band structures, indicated by the dash-dotted line and the dash-dot-dotted line in the right-hand side diagram.

Fig. 16 illustrates the method starting with an n++ emitter. The initial concentration profile and the initial band structure are indicated by solid lines in the left-hand side and right-hand side diagrams, respectively. In this example, the first dopant is an n-type dopant, and the second dopant is a p-type dopant. By application of the first pulsed processing beam, dopant is moved deeper into the material. The depth and the resulting pile-up can be controlled by controlling the processing parameters. In the left-hand side diagram, the resulting concentration profiles of the first dopant for two different treatments with the first pulsed processing beam are shown as dash-dotted line and as dash-dot-dotted line, respectively. The first pulsed processing beam is applied and adjusted such that the maximum depth at which the pile-up occurs is the same for both cases, but the pile-up effect is stronger, i.e., the first dopant is more concentrated at a certain depth in case of the dash-dot-dotted line. In both cases, second dopant is incorporated into the material using the second pulsed processing beam as described above, resulting in a concentration profile of second dopant as indicated by the dotted line. The two different overall resulting concentration profiles, which differ by the concentration profiles of the first dopant, lead to two different band structures, indicated by the dash-dotted line and the dash-dot-dotted line in the right-hand side diagram.

Fig. 17 illustrates the method starting with an n++ emitter. The initial concentration profile and the initial band structure are indicated by solid lines in the left-hand side and right-hand side diagrams, respectively. In this example, the first dopant is an n-type dopant, and the second dopant is a p-type dopant. By application of the first pulsed processing beam, dopant is moved deeper into the material. The depth and the resulting pile-up can be controlled by controlling the processing parameters. In the left-hand side diagram, the resulting concentration profile of the first dopant for one exemplary treatment is shown as dash-dotted line. Second dopant is incorporated into the material using the second pulsed processing beam as described above. This can be done using different processing parameters, resulting in different concentration profiles of the second doping, as exemplarily shown in the left-hand side figure as dotted line and dashed line, respectively. The two different overall resulting concentration profiles, which differ by the concentration profiles of the second dopant, lead to two different band structures, indicated by the dotted line and the dashed line in the right-hand side diagram.

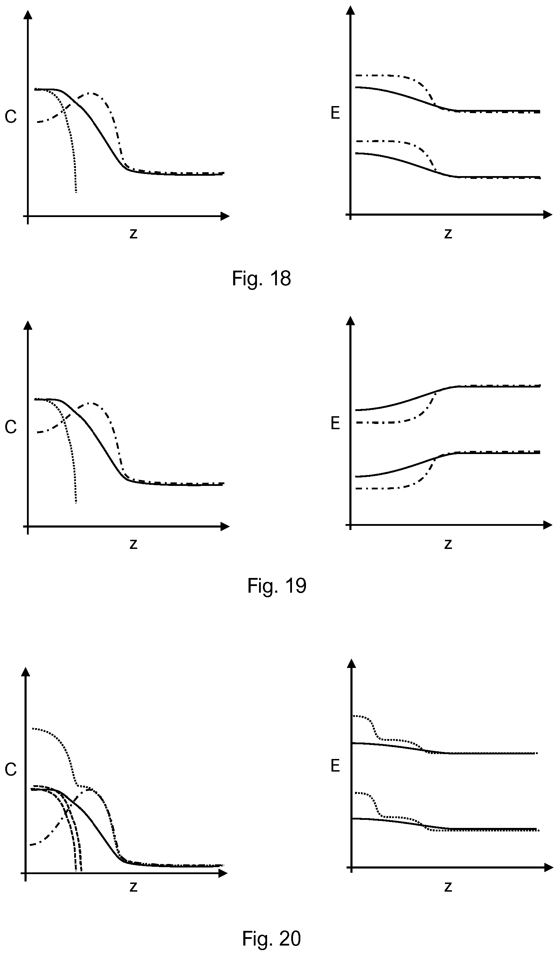

Fig. 18 illustrates the method starting with a p++ emitter. The initial concentration profile and the initial band structure are indicated by solid lines in the left-hand side and right-hand side diagrams, respectively. In this example, the first dopant is a p-type dopant, and the second dopant is also a p-type dopant. The second dopant may be a different element in this case. For instance, the first dopant may be Boron and the second dopant may be Gallium or vice versa. By application of the first pulsed processing beam, dopant is moved deeper into the material. The depth and the resulting pile-up can be controlled by controlling the processing parameters. In the left-hand side diagram, the resulting concentration profile of the first dopant for one exemplary treatment is shown as dash-dotted line. The second dopant is incorporated into the material using the second pulsed processing beam as described above, resulting in a concentration profile of second dopant as indicated by the dotted line. The resulting concentration profiles lead to the band structure exemplarily shown as dash-dotted line in the right-hand side diagram.

Fig. 19 illustrates the method starting with an n++ emitter. The initial concentration profile and the initial band structure are indicated by solid lines in the left-hand side and right-hand side diagrams, respectively. In this example, the first dopant is a n-type dopant, and the second dopant is also a n-type dopant. The second dopant may be a different element in this case. For instance, the first dopant may be Phosphorus and the second dopant may be Aresenic or vice versa. By application of the first pulsed processing beam, dopant is moved deeper into the material. The depth and the resulting pile-up can be controlled by controlling the processing parameters. In the left-hand side diagram, the resulting concentration profile of the first dopant for one exemplary treatment is shown as dash-dotted line. The second dopant is incorporated into the material using the second pulsed processing beam as described above, resulting in a concentration profile of second dopant as indicated by the dotted line. The resulting concentration profiles lead to the band structure exemplarily shown as dash-dotted line in the right-hand side diagram.

Fig. 20 illustrates the method starting with a lightly p-doped material. The initial concentration profile and the initial band structure are indicated by solid lines in the left-hand side and right-hand side diagrams, respectively. The method is used to generate a stepped band structure in this example. In this example, the first dopant is a p-type dopant, and the second dopant is also a p-type dopant. The second dopant is exemplarily the same as the first dopant in this case. By application of the first pulsed processing beam, dopant is moved deeper into the material. The depth and the resulting pile-up can be controlled by controlling the processing parameters. In the left-hand side diagram, the resulting concentration profile of the first dopant for one exemplary treatment is shown as dash-dotted line. The second dopant is incorporated into the material using the second pulsed processing beam as described above. In this example, however, the treatment with the second pulsed processing beam is performed repeatedly, in particular twice. Each treatment results in incorporation of second dopant according to an individual concentration profile as shown by means of the dashed lines in the left-hand side diagram. These two concentrations add up with each other as well as with the concentration profile resulting from the application of the first pulsed processing beam. This leads to an overall dopant concentration profile as shown by means of the dotted line. This concentration profile leads to the band structure exemplarily shown as dashed line in the right-hand side diagram.

### Reference numerals

- 2: doped material
- 4: material
- 6: surface
- 8: first dopant
- 10: area
- 12: first pulsed processing beam
- 14: second dopant
- 16: second pulsed processing beam
- 18: dopant atmosphere
- 20: pile-up area
- 22: first distance
- 24: second distance
- 26: tunnel junction
- 28: processing locations
- 30: first location
- 32: second location
- 34: beam unit
- 36: processing unit
- 38: control unit
- 40: system
- 41: heating device
- 42: heating element
- 44: gas supply unit
- 46: vacuum unit
- 48: transparent window
- 50: chamber
- 52: pulsed laser beam source
- 54: depleted area

## Claims

1. A method for producing a doped material (2), in particular a doped semiconductor, comprising the steps:
providing a material (4), wherein the material comprises a surface (6) and a first dopant (8) in at least an area (10) below the surface (6);
processing the material (4) by directing a first pulsed processing beam (12) onto the surface (6) of the material (4), wherein the processing comprises locally and temporarily melting the material such that the first dopant (8) moves away from the surface (6) and subsequent solidification of the previously locally molten material;
providing a second dopant (14) on the surface of the material; and
incorporating the second dopant (14) into the material (4) by directing a second pulsed processing beam (16) onto the surface (6), wherein incorporating the second dopant (14) comprises locally and temporarily melting the material (4) such that the second dopant (14) moves into the material (4) and subsequent solidification of the previously locally molten material.

2. The method of claim 1,
wherein providing the second dopant (14) on the surface (6) of the material (4) comprises providing a dopant atmosphere (18) above the surface (6) of the material (4).

3. The method of claim 1 or 2,
wherein the first pulsed processing beam (12) causes the first dopant (8) to pile up in a pile-up area (20) at a first distance (22) away from the surface (6) such that a concentration of the first dopant (8) is highest in the pile-up area (20).

4. The method of any one of the preceding claims,
wherein the second pulsed processing beam (16) causes the second dopant (14) to be incorporated into the material (4) up to a second distance (24) away from the surface (6).

5. The method of claim 4,
wherein the second distance (24) is smaller than the first distance (22).

6. The method of any one of the preceding claims,
wherein the first dopant (8) and the second dopant (14) lead to the formation of a tunnel junction (26) in the material (4).

7. The method of any one of the preceding claims,
wherein the first pulsed processing beam (12) and/or the second pulsed processing beam (16) is moved between different processing locations (28) on the surface (6).

8. The method of any one of the preceding claims,
wherein the first pulsed processing beam (12) is applied several times onto a first location (30) on the surface (6) and/or the second pulsed processing beam (16) is applied several times onto a second location (32) on the surface (6).

9. The method of any one of the preceding claims,
wherein the first dopant (8) is different from the second dopant (14).

10. The method of any one of the preceding claims,
wherein one of the first dopant (8) and the second dopant (14) is an n-dopant and the other of the first dopant (8) and the second dopant (14) is a p-dopant, or wherein both the first dopant (8) and the second dopant (14) are n-dopants or wherein both the first dopant (8) and the second dopant (14) are p-dopants.

11. The method of any one of the preceding claims,
wherein the first pulsed processing beam (12) and/or the second pulsed processing beam (16) is a pulsed laser beam.

12. The method of any one of the preceding claims,
wherein the first pulsed processing beam (12) and the second pulsed processing beam (16) are generated using the same beam source, in particular a Near-IR laser beam source.

13. The method of any one of the preceding claims,
wherein a temperature of the material (4) is adjusted to a predetermined temperature value and/or temperature profile.

14. A system (40) for producing a doped material (2), in particular a doped semiconductor, in particular using a method of one of the preceding claims, comprising:
a beam unit (34) adapted to generate a first pulsed processing beam (12) and a second pulsed processing beam (16);
a processing unit (36) adapted to receive a material (4) comprising a surface (6) and a first dopant (8) in at least an area below the surface (6) and to provide a dopant atmosphere (18) above the surface (6) of the material (4), wherein the material (4) comprises a surface (6) and a first dopant (8) in at least an area (10) below the surface (6); and
a control unit (38) configured to control the beam unit (34) and the processing unit (36) such that the following steps are performed:
processing the material (4) by directing a first pulsed processing beam (12) onto the surface (6) of the material (4), wherein the processing comprises locally and temporarily melting the material (4) such that the first dopant (8) moves away from the surface (6) and subsequent solidification of the previously locally molten material;
providing a second dopant (14) on the surface (6) of the material (4);
incorporating the second dopant (14) into the material (4) by directing a second pulsed processing beam (16) onto the surface (6), wherein incorporating the second dopant (14) comprises locally and temporarily melting the material (4) such that the second dopant (14) moves into the material (4) and subsequent solidification of the previously locally molten material.

15. Computer program product comprising a memory and program code stored in the memory, wherein the program code is adapted to cause performance of the method of one of claims 1 to 13 when the program code is executed in a processor.

## Patentansprüche

1. Verfahren zum Herstellen eines dotierten Materials (2), insbesondere eines dotierten Halbleiters, das die folgenden Schritte umfasst:
Bereitstellen eines Materials (4), wobei das Material eine Oberfläche (6) und einen ersten Dotierstoff (8) in wenigstens einem Bereich (10) unter der Oberfläche (6) aufweist;
Bearbeiten des Materials (4), indem ein erster gepulster Bearbeitungsstrahl (12) auf die Oberfläche (6) des Materials (4) gerichtet wird, wobei das Bearbeiten ein lokales und vorübergehendes Schmelzen des Materials umfasst, sodass sich der erste Dotierstoff (8) von der Oberfläche (6) wegbewegt, und anschließendes Verfestigen des zuvor lokal geschmolzenen Materials;
Bereitstellen eines zweiten Dotierstoffes (14) auf der Oberfläche des Materials; und
Einbringen des zweiten Dotierstoffes (14) in das Material (4), indem ein zweiter gepulster Bearbeitungsstrahl (16) auf die Oberfläche (6) gerichtet wird, wobei das Einbringen des zweiten Dotierstoffes (14) ein lokales und vorübergehendes Schmelzen des Materials (4) umfasst, sodass sich der zweite Dotierstoff (14) in das Material (4) hineinbewegt, und anschließendes Verfestigen des zuvor lokal geschmolzenen Materials.

2. Verfahren nach Anspruch 1,
wobei das Bereitstellen des zweiten Dotierstoffes (14) auf der Oberfläche (6) des Materials (4) das Bereitstellen einer Dotierstoffatmosphäre (18) über der Oberfläche (6) des Materials (4) umfasst.

3. Verfahren nach Anspruch 1 oder 2,
wobei der erste gepulste Bearbeitungsstrahl (12) bewirkt, dass sich der erste Dotierstoff (8) in einem Sammelbereich (20) in einem ersten Abstand (22) zu der Oberfläche (6) derart ansammelt, dass eine Konzentration des ersten Dotierstoffes (8) in dem Sammelbereich (20) am höchsten ist.

4. Verfahren nach einem der vorangehenden Ansprüche,
wobei der zweite gepulste Bearbeitungsstrahl (16) bewirkt, dass der zweite Dotierstoff (14) bis zu einem zweiten Abstand (24) zu der Oberfläche (6) in das Material (4) eingebracht wird.

5. Verfahren nach Anspruch 4,
wobei der zweite Abstand (24) kleiner ist als der erste Abstand (22).

6. Verfahren nach einem der vorangehenden Ansprüche,
wobei der erste Dotierstoff (8) und der zweite Dotierstoff (14) zu der Bildung einer Tunnelverbindung (26) in dem Material (4) führen.

7. Verfahren nach einem der vorangehenden Ansprüche,
wobei der erste gepulste Bearbeitungsstrahl (12) und/oder der zweite gepulste Bearbeitungsstrahl (16) zwischen verschiedenen Bearbeitungsstellen (28) auf der Oberfläche (6) bewegt werden.

8. Verfahren nach einem der vorangehenden Ansprüche,
wobei der erste gepulste Bearbeitungsstrahl (12) mehrmals auf eine erste Stelle (30) auf der Oberfläche (6) und/oder der zweite gepulste Bearbeitungsstrahl (16) mehrmals auf eine zweite Stelle (32) auf der Oberfläche (6) aufgebracht werden.

9. Verfahren nach einem der vorangehenden Ansprüche,
wobei sich der erste Dotierstoff (8) von dem zweiten Dotierstoff (14) unterscheidet.

10. Verfahren nach einem der vorangehenden Ansprüche,
wobei einer des ersten Dotierstoffes (8) und des zweiten Dotierstoffes (14) n-dotiert ist und der andere des ersten Dotierstoffes (8) und des zweiten Dotierstoffes (14) p-dotiert ist oder wobei sowohl der erste Dotierstoff (8) als auch der zweite Dotierstoff (14) n-dotiert sind oder wobei sowohl der erste Dotierstoff (8) als auch der zweite Dotierstoff (14) p-dotiert sind.

11. Verfahren nach einem der vorangehenden Ansprüche,
wobei es sich bei dem ersten gepulsten Bearbeitungsstrahl (12) und/oder dem zweiten gepulsten Bearbeitungsstrahl (16) um einen gepulsten Laserstrahl handelt.

12. Verfahren nach einem der vorangehenden Ansprüche,
wobei der erste gepulste Bearbeitungsstrahl (12) und der zweite gepulste Bearbeitungsstrahl (16) unter Verwendung derselben Strahlquelle, insbesondere einer Nah-IR-Laserstrahlquelle, erzeugt werden.

13. Verfahren nach einem der vorangehenden Ansprüche,
wobei eine Temperatur des Materials (4) auf einen vorbestimmten Temperaturwert und/oder ein vorbestimmtes Temperaturprofil eingestellt wird.

14. System (40) zum Herstellen eines dotierten Materials (2), insbesondere eines dotierten Halbleiters, insbesondere unter Einsatz eines Verfahrens nach einem der vorangehenden Ansprüche, umfassend:
eine Strahleinheit (34), die zum Erzeugen eines ersten gepulsten Bearbeitungsstrahls (12) und eines zweiten gepulsten Bearbeitungsstrahls (16) ausgebildet ist;
eine Bearbeitungseinheit (36), die zur Aufnahme eines Materials (4), das eine Oberfläche (6) und einen ersten Dotierstoff (8) in wenigstens einem Bereich unter der Oberfläche (6) aufweist, und zum Bereitstellen einer Dotierstoffatmosphäre (18) über der Oberfläche (6) des Materials (4) ausgebildet ist, wobei das Material (4) eine Oberfläche (6) und einen ersten Dotierstoff (8) in wenigstens einem Bereich (10) unter der Oberfläche (6) aufweist; und
eine Steuereinheit (38), die zum Steuern der Strahleinheit (34) und der Bearbeitungseinheit (36) derart eingerichtet ist, dass die folgenden Schritte durchgeführt werden:
Bearbeiten des Materials (4), indem ein erster gepulster Bearbeitungsstrahl (12) auf die Oberfläche (6) des Materials (4) gerichtet wird, wobei das Bearbeiten ein lokales und vorübergehendes Schmelzen des Materials (4) umfasst, sodass sich der erste Dotierstoff (8) von der Oberfläche (6) wegbewegt, und anschließendes Verfestigen des zuvor lokal geschmolzenen Materials;
Bereitstellen eines zweiten Dotierstoffes (14) auf der Oberfläche (6) des Materials (4);
Einbringen des zweiten Dotierstoffes (14) in das Material (4), indem ein zweiter gepulster Bearbeitungsstrahl (16) auf die Oberfläche (6) gerichtet wird, wobei das Einbringen des zweiten Dotierstoffes (14) ein lokales und vorübergehendes Schmelzen des Materials (4) umfasst, sodass sich der zweite Dotierstoff (14) in das Material (4) hineinbewegt, und anschließendes Verfestigen des zuvor lokal geschmolzenen Materials.

15. Computerprogrammprodukt mit einem Speicher und in dem Speicher gespeicherten Programmcode, wobei der Programmcode dazu ausgebildet ist, die Durchführung des Verfahrens nach einem der Ansprüche 1 bis 13 zu veranlassen, wenn der Programmcode in einem Prozessor ausgeführt wird.

## Revendications

1. Procédé de production d'un matériau dopé (2), en particulier d'un semiconducteur dopé, comprenant les étapes de :
fourniture d'un matériau (4), dans lequel le matériau comprend une surface (6) et un premier dopant (8) dans au moins une zone (10) située sous la surface (6) ;
traitement du matériau (4) en dirigeant un premier faisceau de traitement pulsé (12) sur la surface (6) du matériau (4), dans lequel le traitement comprend la fusion locale et temporaire du matériau de telle sorte que le premier dopant (8) s'éloigne de la surface (6) et la solidification ultérieure du matériau précédemment fondu localement ;
fourniture d'un second dopant (14) sur la surface du matériau ; et
incorporation du second dopant (14) dans le matériau (4) en dirigeant un second faisceau de traitement pulsé (16) sur la surface (6), dans lequel l'incorporation du second dopant (14) comprend la fusion locale et temporaire du matériau (4) de telle sorte que le second dopant (14) se déplace dans le matériau (4) et la solidification ultérieure du matériau précédemment fondu localement.

2. Procédé selon la revendication 1,
dans lequel la fourniture du second dopant (14) sur la surface (6) du matériau (4) comprend la fourniture d'une atmosphère de dopant (18) au-dessus de la surface (6) du matériau (4).

3. Procédé selon la revendication 1 ou 2,
dans lequel le premier faisceau de traitement pulsé (12) provoque l'accumulation du premier dopant (8) dans une zone d'accumulation (20) à une première distance (22) de la surface (6) de telle sorte qu'une concentration du premier dopant (8) est la plus élevée dans la zone d'accumulation (20).

4. Procédé selon l'une quelconque des revendications précédentes,
dans lequel le second faisceau de traitement pulsé (16) provoque l'incorporation du second dopant (14) dans le matériau (4) jusqu'à une seconde distance (24) de la surface (6).

5. Procédé selon la revendication 4,
dans lequel la seconde distance (24) est inférieure à la première distance (22).

6. Procédé selon l'une quelconque des revendications précédentes,
dans lequel le premier dopant (8) et le second dopant (14) conduisent à la formation d'une jonction tunnel (26) dans le matériau (4).

7. Procédé selon l'une quelconque des revendications précédentes,
dans lequel le premier faisceau de traitement pulsé (12) et/ou le second faisceau de traitement pulsé (16) sont déplacés entre différents emplacements de traitement (28) sur la surface (6).

8. Procédé selon l'une quelconque des revendications précédentes,
dans lequel le premier faisceau de traitement pulsé (12) est appliqué plusieurs fois sur un premier emplacement (30) sur la surface (6) et/ou le second faisceau de traitement pulsé (16) est appliqué plusieurs fois sur un second emplacement (32) sur la surface (6).

9. Procédé selon l'une quelconque des revendications précédentes,
dans lequel le premier dopant (8) est différent du second dopant (14).

10. Procédé selon l'une quelconque des revendications précédentes,
dans lequel l'un parmi le premier dopant (8) et le second dopant (14) est un dopant n et l'autre parmi le premier dopant (8) et le second dopant (14) est un dopant p, ou dans lequel le premier dopant (8) et le second dopant (14) sont tous deux des dopants n ou dans lequel le premier dopant (8) et le second dopant (14) sont tous deux des dopants p.

11. Procédé selon l'une quelconque des revendications précédentes,
dans lequel le premier faisceau de traitement pulsé (12) et/ou le second faisceau de traitement pulsé (16) est un faisceau laser pulsé.

12. Procédé selon l'une quelconque des revendications précédentes,
dans lequel le premier faisceau de traitement pulsé (12) et le second faisceau de traitement pulsé (16) sont générés à l'aide de la même source de faisceau, en particulier une source de faisceau laser proche-IR.

13. Procédé selon l'une quelconque des revendications précédentes,
dans lequel une température du matériau (4) est ajustée à une valeur de température et/ou un profil de température prédéterminés.

14. Système (40) de production d'un matériau dopé (2), en particulier d'un semiconducteur dopé, en particulier utilisant un procédé selon l'une des revendications précédentes, comprenant :
une unité de faisceau (34) conçue pour générer un premier faisceau de traitement pulsé (12) et un second faisceau de traitement pulsé (16) ;
une unité de traitement (36) conçue pour recevoir un matériau (4) comprenant une surface (6) et un premier dopant (8) dans au moins une zone située sous la surface (6) et pour fournir une atmosphère de dopant (18) au-dessus de la surface (6) du matériau (4), dans lequel le matériau (4) comprend une surface (6) et un premier dopant (8) dans au moins une zone (10) située sous la surface (6) ; et
une unité de commande (38) configurée pour commander l'unité de faisceau (34) et l'unité de traitement (36) de telle sorte que les étapes suivantes soient réalisées :
le traitement du matériau (4) en dirigeant un premier faisceau de traitement pulsé (12) sur la surface (6) du matériau (4), dans lequel le traitement comprend la fusion locale et temporaire du matériau (4) de telle sorte que le premier dopant (8) s'éloigne de la surface (6) et la solidification ultérieure du matériau précédemment fondu localement ;
la fourniture d'un second dopant (14) sur la surface (6) du matériau (4) ;
l'incorporation du second dopant (14) dans le matériau (4) en dirigeant un second faisceau de traitement pulsé (16) sur la surface (6), dans lequel l'incorporation du second dopant (14) comprend la fusion locale et temporaire du matériau (4) de telle sorte que le second dopant (14) se déplace dans le matériau (4) et la solidification ultérieure du matériau précédemment fondu localement.

15. Produit de programme informatique comprenant une mémoire et un code de programme stocké dans la mémoire, dans lequel le code de programme est conçu pour provoquer l'exécution du procédé selon l'une des revendications 1 à 13 lorsque le code de programme est exécuté dans un processeur.
